# EUROPÄISCHE PATENTSCHRIFT

(11) **EP 2 167 285 B1**
(45) Veröffentlichungstag und Bekanntmachung des Hinweises auf die Patenterteilung: **18.04.2018**
(21) Anmeldenummer: 08758047.8
(22) Anmeldetag: 05.05.2008
(51) Int. Cl.: B25J 15/06, H01L 21/67, H01L 21/683

(54) **GREIFERSYSTEM MIT EINEM BERNOULLI-GREIFER ZUR AUFNAHME VON FLÄCHIGEN BAUTEILEN WIE SILIZIUMBASIERTEN WAFERN**
GRIPPER SYSTEM WITH A BERNOULLI GRIPPER FOR RECEIVING PLANAR COMPONENTS SUCH AS SILICON-BASED WAFERS
SYSTÈME DE PRÉHENSION AVEC UNE ORGANE DE PRÉHENSION BERNOULLI POUR RÉCEPTION DE COMPOSANTS PLANS TELS QUE DES WAFERS À BASE DE SILICIUM

(30) Priorität: 31.05.2007 DE 202007007721 U
(43) Veröffentlichungstag der Anmeldung: 31.03.2010
(73) Patentinhaber: Jonas & Redmann Automationstechnik GmbH, 10553 Berlin (DE)
(72) Erfinder: JONAS, Stefan, 12351 Berlin (DE); REDMANN, Lutz, 14532 Kleinmachnow (DE)
(74) Vertreter: Hoffmann, Klaus-Dieter
(86) Internationale Anmeldenummer: PCT/DE2008/000789
(87) Internationale Veröffentlichungsnummer: WO 2008/145085

(56) Entgegenhaltungen:
- EP-A- 1 271 623
- EP-A- 1 685 930
- EP-A1- 0 611 273
- US-A- 4 852 926
- US-A1- 2002 130 524
- US-A1- 2004 041 420

## Beschreibung

Die Erfindung betrifft ein Greifersystem mit einem Bernoulli-Greifer zur Aufnahme von flächigen Bauteilen wie siliziumbasierten Wafern, der aufweist:
einen mit einem steuerbaren Roboterarm verbundenden Klemmring; eine über ein trichterförmiges Bauelement mit dem Klemmring verbundenen Prallscheibe mit einer Greiffläche, die mit einem das trichterförmige Bauelement und die Prallscheibe durchsetzenden Strömungssystem kommuniziert, über das nach Anlegen eines Überdrucks an den Bernoulli-Greifer ein Unterdruck an der Greiffläche der Prallscheibe zum Ansaugen eines zugreifenden siliziumbasierten Wafers zu erzeugen ist; und
eine in der Greiffläche integrierte Anlagefläche eines Auflagerings, durch die ein rutschfestes Verfahren des an der Greiffläche angesaugten siliziumbasierten Wafers gegeben ist.

Aus der US2002/0130524A1 ist ein Greifersystem mit einem Bernoulli-Greifer zum Anheben und Befördern lithografischer Platten bekannt, mit dem ein Schwingen und Aneinanderstoßen letzterer minimiert und zugleich eine Geräuschminderung erreicht werden soll. Hierzu weist der Bernoulli-Greifer einen Greifkopf, der aus Gummi hergestellt sein kann, sowie ein Strömungssystem mit einer Überdruckquelle eines Strömungsmittels auf. Die Greiffläche des Greifkopfes ist in zwei funktionale Zonen unterteilt, und zwar in eine Zone zum Anheben einer lithografischen Platte auf dem Bernoulli-Prinzip und eine Zone zum Dämpfen von Vibrationen und Schwingungen. Letztere weist eine Folge gleichmäßig verteilter konzentrischer Rillen, die in Nähe des Außenumfangs der Greiffläche angeordnet sind, auf und kann mit Borsten versehen sein. Die Greiffläche des Greifkopfes bildet beim Handhaben einer lithografischen Platte zusammen mit deren Oberseite einen Strömungskanal des Strömungssystems, der von der Mitte der Greiffläche aus mit dem Strömungsmittel nach beiden Seiten hin gespeist wird, wobei der Spalt des Strömungskanals nie zu Null und damit die Strömung des Strömungsmittels nie unterbrochen wird. Nähert sich die lithografische Platte bei ihrer Handhabung zu dicht an die Greiffläche des Greifkopfes, so wird die Strömungsgeschwindigkeit des längsströmenden Strömungsmittels kleiner, womit der Unterdruck reduziert wird und - bezogen auf die Greiffläche - eine Abwärtsbewegung der lithografischen Platte und damit eine Selbstregulierung einer Gleichgewichtsstellung letzterer erfolgen Ein unmittelbares Anlegen der lithographischen Platte an die Greiffläche des Greifkopfes des Bernoulli-Greifers erfolgt nicht.

Es ist aus der Praxis der automatisierten Herstellung von bruchgefährdeten siliziumbasierten Wafern bzw. von Solarzellen bekannt, für vielfältige Handlingsaufgaben Greifersysteme mit auf dem Bernoulli-Prinzip basierenden Greifern einzusetzen, mit denen durch Erzeugung eines Unterdrucks an der Greiffläche eines Bernoulli-Greifers eine vereinzelte berührungslose Aufnahme eines Wafers in einer gerade vorhandenen Position möglich ist. Hierbei hat sich jedoch als eine Gefahrenquelle für eine Waferbeschädigung der ansaugbedingte ungebremste Anschlag des jeweils zugreifenden Wafers an der Greiffläche des Bernoulli-Greifers erwiesen.

Aus der EP0611273A1 ist zusätzlich ein Greifersystem mit einem Bernoulli-Greifer zum Anheben und Befördern von scheibenförmigen Gegenständen wie Siliziumscheiben bekannt. Hierzu erfolgt ein unmittelbares Anlegen einer Siliziumscheibe an einer in einer Greiffläche des Bernoulli-Greifers integrierten Anlagefläche eines Auflagerings aus z.B. Silikon oder teflonbeschichtetes Silikon zum sicheren Halten der Siliziumscheibe an dem Bernoulli-Greifer. Das Greifersystem beinhaltet jedoch nicht eine Vorrichtung zur Beschützung der Siliziumscheibe gegen einen ansaugbedingten ungebremsten Anschlag der Siliziumscheibe an der Greiffläche des Bernoulli-Greifers.

Der vorliegenden Erfindung liegt die Aufgabe zugrunde, ein Greifersystem der eingangs erwähnten Art zur Verfügung zu stellen, mit dem zur Verringerung des Ausschusses bei der berührungslosen Aufnahme von flächigen Bauteilen wie siliziumbasierten Wafern ein äußerst stoßschonendes Anlegen des zu greifenden Wafers an der Greiffläche des Bernoulli-Greifers des Greifersystems möglich ist.

Diese Aufgabe wird erfindungsgemäß gelöst durch eine an dem Bernoulli-Greifer umlaufend adaptierte Dämpfungseinrichtung, deren Umriß -- gesehen in der Draufsicht des Bernoulli-Greifers - diesen konturenmäßig umlaufend überragt und die von einer Bürste mit elastischen Borsten gebildet ist, die - gesehen in der Seitenansicht des Bernoulli-Greifers - über diesen um eine vorbestimmte Strecke vorragen und für den zu greifenden siliziumbasierten Wafer in dessen zur Greiffläche ansaugbedingten Anflug als erster Kontakt einen solchen Dämpfungswiderstand bilden, dass der siliziumbasierte Wafer stoßschonend an der Anlagefläche des Auflagerings, die gummiert ist, zur Anlage kommt.

Vorzugsweise liegt die vorbestimmte Strecke, entsprechend der die elastischen Borsten der Bürste über den Bernoulli-Greifer - gesehen in dessen Seitenansicht - vorragen, im Bereich von 1,5 mm bis 3,5 mm.

Vorzugsweise sind zu frei auslaufenden Borstenenden der elastischen Borsten der Bürste entgegengesetzte Borstenenden der elastischen Borsten der Bürste in einem umlaufenden Bürstenrand befestigt, der in einer umlaufenden Klemmnut des Bernoulli-Greifers auswechselbar gehaltert ist, die von dem Klemmring und dem trichterförmigen Bauelement gebildet ist.

Es ist auch denkbar, die Dämpfungseinrichtung des Greifersystems in Form eines kreisförmigen Folienzuschnitts aus Kunststoff mit sich vom Umfang des letzteren radial einwärts erstreckenden, durch Schlitze voneinander getrennten elastischen Lamellen auszubilden, die für die erforderliche Dämpfung beim ansaugbedingten Anflug des zu greifenden flächigen Bauteils sorgen. Äquivalente Ausführungsformen sind ebenfalls möglich.

Bevorzugt sind - gesehen in der Draufsicht des Bernoulli-Greifers - die Prallscheibe und die die Dämpfungseinrichtung bildende Bürste koaxial zur Längsachse des Bernoulli-Greifers angeordnet und ein Umriß der Greiffläche der Prallscheibe und ein Umriß der Bürste kreisförmig. Weiterhin können die elastischen Borsten der Bürste - gesehen in der Draufsicht des Bernoulli-Greifers - einen offenen Kreisring von ca. 340° bilden, wobei der borstenfreie Ringabschnitt der Bürste einem kapazitiven Sensor zur Erkennung des an der Greiffläche angesaugten siliziumbasierten Wafers räumlich zugeordnet ist. Auch können die elastischen Borsten der Bürste zur Ebene der Greiffläche der Prallscheibe unter einem Winkel von 16,5° ± 1° abwärts geneigt verlaufen. Bevorzugt bestehen die elastischen Borsten der Bürste aus Polyamid. Das erfindungsgemäße Greifersystem gewährleistet, dass der anzusaugende Wafer in jedem Fall zuerst mit den elastischen Borsten der Bürste des Greifersystems in Kontakt kommt und somit im ansaugbedingten Anflug zur Greiffläche des Bernoulli-Greifers behutsam auf mechanische Weise gedämpft und dann stoßschonend an der gummierten Anlagefläche des Anlagerings des Bernoulli-Greifers zur Anlage gebracht wird. Hierbei ist unbedeutend, ob das flächige Bauteil parallel zur gummierten Anlagefläche des Bernoulli-Greifers liegt oder nicht, vielmehr wird in jedem Fall die Gefahr einer Beschädigung des bruchgefährdeten Wafers bei seiner Handhabung vermindert und dessen Ausschuss somit beträchtlich vermindert. Die gummierte Anlagefläche sorgt für eine zum schnellen seitwärtes Verfahren notwendige Reibung zwischen dem zu greifenden Wafer und der Greiffläche des Bernoulli-Greifers.

Vorteilhafterweise kann die Dämpfungseinrichtung des Greifersystems, die an dem Bernoulli-Greifer umlaufend adaptiert ist und deren Umriß - gesehen in der Draufsicht des Bernoulli-Greifers - diesen konturenmäßig umlaufend überragt, auch von einem in sich geschlossenen dichtlippenartigen Gummiring aus weichem Material gebildet sein, durch den der siliziumbasierte Wafer in seiner ansaugbedingten Anlage an der in der Greiffläche integrierten Anlagefläche des Auflagerings, die gummiert ist, umfangsmäßig hermetisch gegenüber der Prallscheibe, die von dem einen ersten Luftanschluss und einen zweiten Luftanschluss aufweisenden Strömungssystem durchsetzt ist, abgedichtet ist und die für den zu greifenden siliziumbasierten Wafer in dessen zur Greiffläche ansaugbedingten Anflug als erster Kontakt einen solchen Dämpfungswiderstand bildet, dass der siliziumbasierte Wafer stoßschonend an der Anlagefläche des Auflagerings, die gummiert ist, zur Anlage kommt. Bei dieser Ausführungsform des Greifersystems ist der Betrieb des Bernoulli-Greifers unmittelbar nach dem ansaugbedingten Anlegen des siliziumbasierten Wafers an der Anlagefläche, die gummiert ist, durch Einschalten einer an den ersten Luftanschluss des Strömungssystems angeschlossenen Vakuumpumpe auf Vakuumbetrieb umzustellen, während zugleich der zweite Luftanschluss des Strömungssystems, der zur Erzeugung der Druckdifferenz zum Ansaugen des siliziumbasierten Wafers mit Luft beaufschlagt war, abzuschalten ist. Wenn der Bernoulli-Greifer den Wafer ansaugt, zieht sich der dichtlippenartige Gummiring zusammen und bildet einen kompletten Dichtkreis mit dem Wafer. Innerhalb des Dichtkreises kann sich ein Vakuum aufbauen, so dass der Wafer durch atmosphärischen Außendruck an der gummierten Anlagefläche angedrückt und rutschfest festgehalten wird. Der Luftverbrauch kann auf diese Weise bei sicherem Halten des Wafers an der gummierten Anlagefläche des Auflagerings beträchtlich vermindert werden. Auch hier kann ein kapazitiver Sensor zur Erkennung des an der Greiffläche angesaugten Wafers am Bernoulli-Greifer vorgesehen sein. Bevorzugte Ausführungsformen des erfindungsgemäßen Greifersystems werden nun anhand der Zeichnungen erläutert. In diesen sind:
**Fig. 1** eine geschnittene Seitenansicht eines schematisch dargestellten Greifersystems mit einem Bernoulli-Greifer in Zuordnung zu einem zu greifenden Wafer,
**Fig. 2** eine Perspektivdarstellung des Greifersystems, gesehen von unten, ohne den zu greifenden Wafer,
**Fig. 3** eine Perspektivdarstellung des Greifersystems, gesehen von oben, ohne den zu greifenden Wafer und
**Fig. 4** eine der Fig. 2 entsprechende Perspektivdarstellung eines Greifersystems, wobei die Dämpfungseinrichtung des Greifersystems von einem in sich geschlossenen Gummiring gebildet ist.

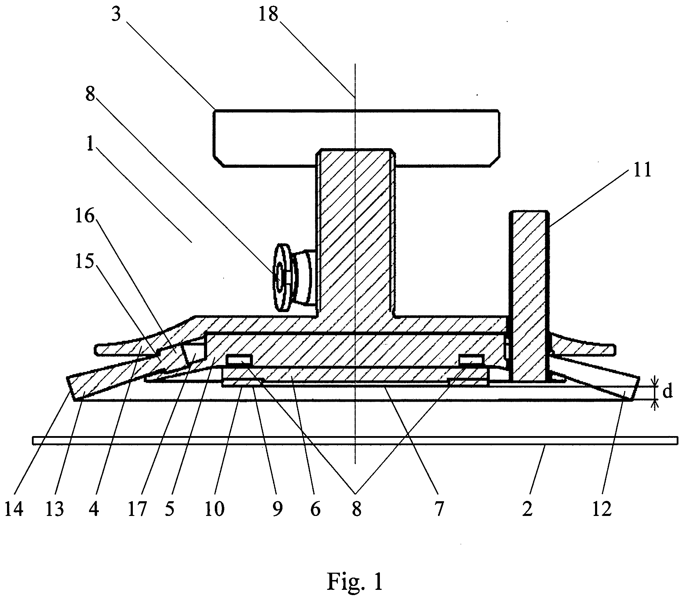

Wie aus den Fig. 1 bis 3 zu ersehen ist, umfasst das Greifersystem einen Bernoulli-Greifer 1 zur berührungslosen Aufnahme von flächigen Bauteilen wie siliziumbasierten Wafern 2, der sich im Wesentlichen zusammensetzt aus einem Klemmring 4, der mit mindestens einem steuerbaren Roboterarm 3 verbunden ist, einer Prallscheibe 6, die mit dem Klemmring 4 über ein trichterförmiges Bauelement 5 verbunden ist und eine Greiffläche 7 aufweist, in der eine Anlagefläche 9 eines Auflageringes 10, die gummiert ist, integriert ist, und einem das trichterförmige Bauelement 5 und die Prallscheibe 6 durchsetzenden Strömungssystem 8, das mit der Greiffläche 7 des Bernoulli-Greifers 1 kommuniziert. Weiterhin umfasst das Greifersystem eine an dem Bernoulli-Greifer 1 umlaufend adaptierte Dämpfungseinrichtung in Form einer Bürste 12 mit elastischen Borsten 13 sowie einen kapazitiven Sensor 11 zur Erkennung eines vom Bernoulli-Greifer 1 aufgenommenen siliziumbasierten Wafers 2.

Beim Anlegen eines Überdrucks an den Bernoulli-Greifer 1 wird über das Strömungssystem 8 ein Unterdruck an der Greiffläche 7 der Prallscheibe 6 zum Ansaugen eines zu greifenden siliziumbasierten Wafers 2 aufgrund der gebildeten Druckdifferenz erzeugt. Da, wie am besten Fig. 1 verdeutlicht, die Prallscheibe 6 und die die Dämpfungseinrichtung bildende Bürste 12 koaxial zur Längsachse 18 des Bernoulli-Greifers 1 angeordnet sind und der kreisförmige Umriß der Bürste 12 - gesehen in der Draufsicht des Bernoulli-Greifers 1 - diesen und damit die Greiffläche 7 der Prallscheibe 6, die kreisförmig ist, konturenmäßig umlaufend überragt, kommt der zu greifende siliziumbasierte Wafer 2 beim ansaugbedingten Anflug zur Greiffläche 7 in jedem Fall zuerst mit den elastischen Borsten 13 der Bürste 12 in Kontakt, die - gesehen in der Seitenansicht des Bernoulli-Greifers 1 - über den Klemmring 4, das trichterförmige Bauelement 5 und die Prallscheibe 6 des Bernoulli-Greifers 1 um eine vorbestimmte Strecke d im Bereich von 1,5 mm bis 3,5 mm vorragen. Die elastischen Borsten 13 der Bürste 12, die gemäß Fig. 1 zur Ebene der Greiffläche 7 der Prallscheibe 6 unter einem Winkel von 16,5⁰ ± 1⁰ abwärts geneigt verlaufen, bilden für den zu greifenden siliziumbasierten Wafer 2 in dessen zur Greiffläche 7 ansaugbedingten Anflug als erster Kontakt einen solchen Dämpfungswiderstand, dass der siliziumbasierte Wafer 2 stoßschonend an der Anlagefläche 9, die gummiert ist, zur Anlage kommt. Die Bruchgefährdung des siliziumbasierten Wafers 2 wird somit auf mechanische und zugleich Energie sparende Weise beträchtlich herabgesetzt.

Wie aus Fig. 1 weiterhin hervorgeht, sind die zu den frei auslaufenden Borstenenden 14 entgegengesetzten Borstenenden 15 in einem umlaufenden Bürstenrand 16 befestigt, der in einer umlaufenden Klemmnut 17 des Bernoulli-Greifers 1 auswechselbar gehaltert ist, die von dem Klemmring 4 und dem trichterförmigen Bauelement 5 gebildet ist. Eine Auswechselung der Dämpfungseinrichtung des Greifersystems entsprechend der Flächengröße des zu greifenden siliziumbasierten Wafers 2 ist somit bei Bedarf in geeigneter Weise möglich.

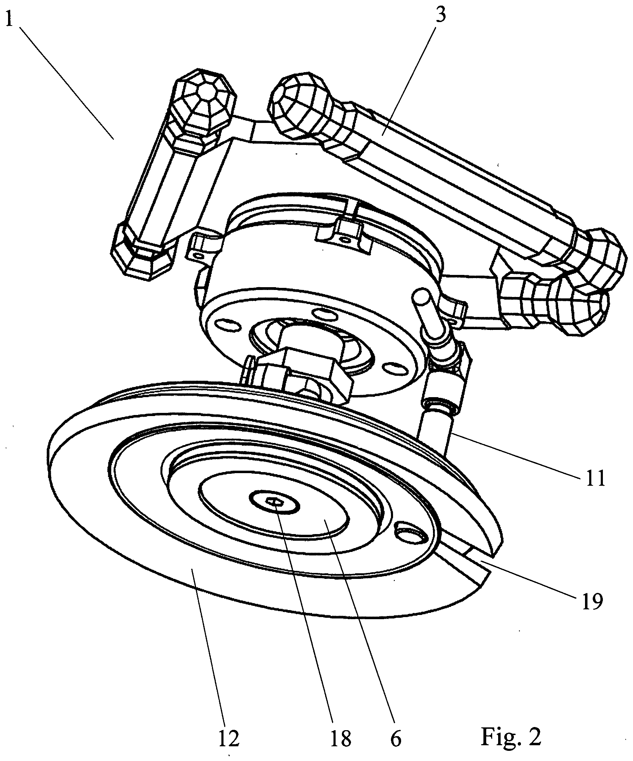

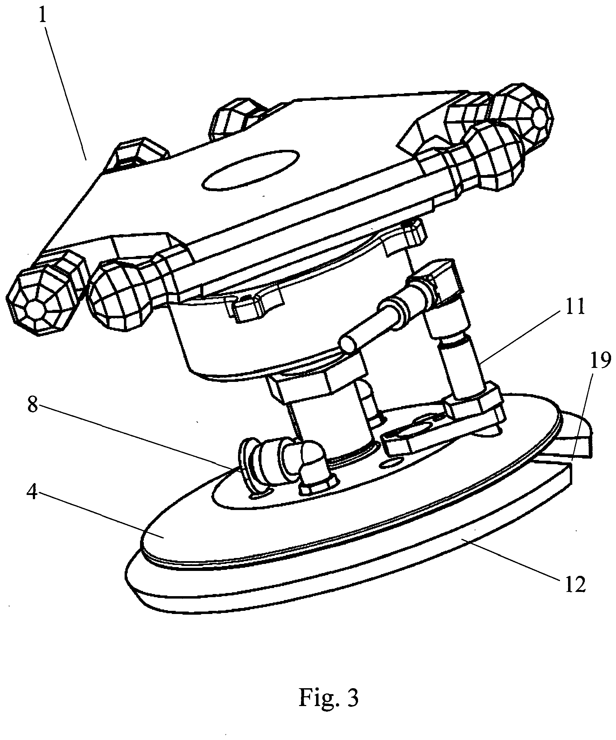

Die Fig. 2 und 3 zeigen, dass bei der dargestellten Ausführungsform des Greifersystems die elastischen Borsten 13 der Bürste 12 - gesehen in der Draufsicht des Bernoulli-Greifers 1 - einen offenenen Kreisring von ca. 340⁰ bilden, wobei der borstenfreie Ringabschnitt 19 der Bürste 12 dem kapazitiven Sensor 11 des Greifersystems zur Erkennung des angesaugten siliziumbasierten Wafers 2 räumlich zugeordnet ist.

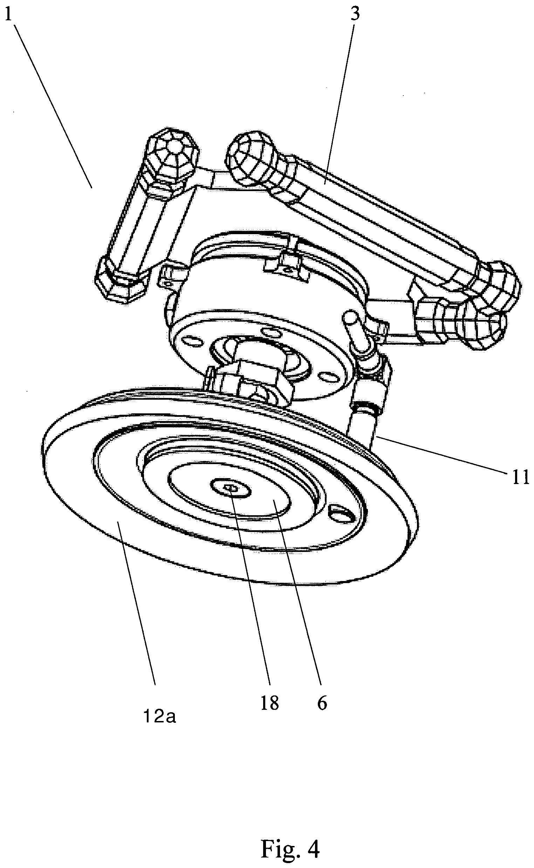

Gemäß Fig. 4 ist die Dämpfungseinrichtung eines Greifersystems, die an dem Bernoulli-Greifer 1 umlaufend adaptiert ist und diesen konturenmäßig umlaufend überragt, von einem in sich geschlossenen dichtlippenartigen Gummiring 12a aus geeignetem elastischen, sehr weichem Material gebildet, durch den der siliziumbasierte Wafer 2 in seiner ansaugbedingten Anlage an der Anlagefläche 9 des Auflagerings 10, die gummiert und in der Greiffläche 7 integriert ist, umfangsmäßig hermetisch gegenüber der vom Strömungssystem 8 durchsetzten Prallscheibe 6 abgedichtet ist. Der Betrieb des Greifersystems ist unmittelbar nach dem ansaugbedingten Anlegen des siliziumbasierten Wafers 2 an der Anlagefläche 9 des Anlagerings 10 des Bernoulli-Greifers 1, die gummiert ist, durch Einschalten einer an einen ersten Luftanschluss des Strömungssystems 8 angeschlossenen Vakuumpumpe auf Vakuumbetrieb umzustellen, während zugleich ein zweiter Luftanschluss des Strömungssystems 8, der zur Erzeugung der Druckdifferenz zum Ansaugen des siliziumbasierten Wafers 2 mit Luft beanschlagt war, abzuschalten ist. Wenn der Bernoulli-Greifer 1 den siliziumbasierten Wafer 2 ansaugt, zieht sich der in sich geschlossene dichtlippenartige Gummiring 12a zusammen und bildet einen kompletten Dichtkreis mit dem siliziumbasierten Wafer 2. Innerhalb des Dichtkreises kann sich ein Vakuum aufbauen, so dass der siliziumbasierte Wafer 2 durch atmosphärischen Druck an der Anlagefläche 9, die gummiert ist, angedrückt und rutschfest gehalten wird. Der Luftverbrauch wird auf diese Weise bei sicherem Halten des siliziumbasierten Wafers 2 an der Anlagefläche 9 des Auflagerings 10 beträchtlich vermindert.

### Bezugszeichenliste:

1 Bernoulli-Greifer
2 siliziumbasierter Wafer
3 steuerbarer Roboterarm
**4** Klemmring
**5** trichterförmiges Bauelement
**6** Prallscheibe
**7** Greiffläche
**8** Strömungssystem
**9** Anlagefläche
**10** Auflagering
**11** kapazitiver Sensor
**12** Bürste
**12a** in sich geschlossener dichtlippenartiger Gummiring
**13** elastische Borsten
**14** frei auslaufende Borstenenden
**15** entgegengesetzte Borstenenden
**16** umlaufender Bürstenrand
**17** umlaufender Klemmnut
**18** Längsachse
**19** borstenfreier Ringabschnitt
**d** vorbestimmte Strecke

## Patentansprüche

1. Greifersystem mit einem Bernoulli-Greifer (1) zur Aufnahme von flächigen Bauteilen wie siliziumbasierten Wafern (2), der aufweist:
einen mit einem steuerbaren Roboterarm (3) verbundenden Klemmring (4);
eine über ein trichterförmiges Bauelement (5) mit dem Klemmring (4) verbundenen Prallscheibe (6) mit einer Greiffläche (7), die mit einem das trichterförmige Bauelement (5) und die Prallscheibe (6) durchsetzenden Strömungssystem (8) kommuniziert, über das nach Anlegen eines Überdrucks an den Bernoulli-Greifer (1) ein Unterdruck an der Greiffläche (7) der Prallscheibe (6) zum Ansaugen eines zu greifenden siliziumbasierten Wafers (2) zu erzeugen ist; und
eine in der Greiffläche (7) integrierte Anlagefläche (9) eines Auflagerings (10), durch die ein rutschfestes Verfahren des an der Greiffläche (7) angesaugten siliziumbasierten Wafers (2) gegeben ist, **gekennzeichnet durch**
eine an dem Bernoulli-Greifer (1) umlaufend adaptierte Dämpfungseinrichtung, deren Umriß - gesehen in der Draufsicht des Bernoulli-Greifers (1) - diesen konturenmäßig umlaufend überragt und die von einer Bürste (12) mit elastischen Borsten (13) gebildet ist, die - gesehen in der Seitenansicht des Bernoulli-Greifers (1) - über diesen um eine vorbestimmte Strecke (d) vorragen und für den zu greifenden siliziumbasierten Wafer (2) in dessen zur Greiffläche (7) ansaugbedingten Anflug als erster Kontakt einen solchen Dämpfungswiderstand bilden, dass der siliziumbasierte Wafer (2) stoßschonend an der Anlagefläche (9) des Auflagerings (10), die gummiert ist, zur Anlage kommt.

2. Greifersystem nach Anspruch 1, **dadurch gekennzeichnet, dass** die vorbestimmte Strecke (d), entsprechend der die elastischen Borsten (13) der Bürste (12) über den Bernoulli-Greifer (1) - gesehen in dessen Seitenansicht - vorragen, im Bereich von 1,5 mm bis 3,5 mm liegt.

3. Greifersystem nach einem der vorhergehenden Ansprüche, **dadurch gekennzeichnet, dass** zu frei auslaufenden Borstenenden (14) der elastischen Borsten (13) der Bürste (12) entgegengesetzte Borstenenden (15) der elastischen Borsten (13) der Bürste (12) in einem umlaufenden Bürstenrand (16) befestigt sind, der in einer umlaufenden Klemmnut (17) des Bernoulli-Greifers (1) auswechselbar gehaltert ist, die von dem Klemmring (4) und dem trichterförmigen Bauelement (5) gebildet ist.

4. Greifersystem nach einem der vorhergehenden Ansprüche, **dadurch gekennzeichnet, dass** - gesehen in der Draufsicht des Bernoulli-Greifers (1) - die Prallscheibe (6) und die die Dämpfungseinrichtung bildende Bürste (12) koaxial zur Längsachse (18) des Bernoulli-Greifers (1) angeordnet sind und dass ein Umriß der Greiffläche (7) der Prallscheibe (6) und ein Umriß der Bürste (12) kreisförmig sind.

5. Greifersystem nach einem der vorhergehenden Ansprüche, **dadurch gekennzeichnet, dass** die elastischen Borsten (13) der Bürste (12) - gesehen in der Draufsicht des Bernoulli-Greifers (1) - einen offenen Kreisring von ca. 340° bilden, wobei der borstenfreie Ringabschnitt (19) der Bürste (12) einem kapazitiven Sensor (11) zur Erkennung des an der Greiffläche (7) angesaugten siliziumbasierten Wafers (2) räumlich zugeordnet ist.

6. Greifersystem nach einem der vorhergehenden Ansprüche, **dadurch gekennzeichnet, dass** die elastischen Borsten (13) der Bürste (12) zur Ebene der Greiffläche (7) der Prallscheibe (6) unter einem Winkel von 16,5° ± 1° abwärts geneigt verlaufen.

7. Greifersystem nach einem der vorhergehenden Ansprüche, **dadurch gekennzeichnet, dass** die elastischen Borsten (13) der Bürste (12) aus Polyamid bestehen.

8. Greifersystem mit einem Bernoulli-Greifer (1) zur Aufnahme von flächigen Bauteilen wie siliziumbasierten Wafern (2), der aufweist:
einen mit einem steuerbaren Roboterarm (3) verbundenden Klemmring (4); eine über ein trichterförmiges Bauelement (5) mit dem Klemmring (4) verbundenen Prallscheibe (6) mit einer Greiffläche (7), die mit einem das trichterförmige Bauelement (5) und die Prallscheibe (6) durchsetzenden Strömungssystem (8) kommuniziert, über das nach Anlegen eines Überdrucks an den Bernoulli-Greifer (1) ein Unterdruck an der Greiffläche (7) der Prallscheibe (6) zum Ansaugen des zu greifenden siliziumbasierten Wafers (2) zu erzeugen ist; und
eine in der Greiffläche integrierte Anlagefläche (9) eines Auflagerings (10), durch
die ein rutschfestes Verfahren des an der Greiffläche (7) angesaugten siliziumbasierten Wafers gegeben ist, **gekennzeichnet durch** eine an dem Bernoulli-Greifer (1) umlaufend adaptierte Dämpfungseinrichtung, deren Umriß - gesehen in der Draufsicht des Bernoulli-Greifers (1) - diesen konturenmäßig umlaufend überragt und die von einem in sich geschlossenen dichtlippenartigen Gummiring (12a) aus weichem Material gebildet ist, durch den der siliziumbasierte Wafer (2) in seiner ansaugbedingten Anlage an der in der Greiffläche (7) integrierten Anlagefläche (9) des Auflagerings (10), die gummiert ist, umfangsmäßig hermetisch gegenüber der Prallscheibe (6), die von dem einen ersten Luftanschluss und einen zweiten Luftanschluss aufweisenden Strömungssystem (8) durchsetzt ist, abgedichtet ist und die für den zu greifenden siliziumbasierten Wafer (2) in dessen zur Greiffläche (7) ansaugbedingten Anflug als erster Kontakt einen solchen Dämpfungswiderstand bildet, dass der siliziumbasierte Wafer (2) stoßschonend an der Anlagefläche (9) des Auflagerings (10), die gummiert ist, zur Anlage kommt, wobei der Betrieb des Bernoulli-Greifers (1) unmittelbar nach dem ansaugbedingten Anlegen des siliziumbasierten Wafers (2) an der Anlagefläche (9), die gummiert ist, durch Einschalten einer an den ersten Luftanschluss des Strömungssystems (8) angeschlossenen Vakuumpumpe auf Vakuumbetrieb umzustellen ist, während zugleich der zweite Luftanschluss des Strömungssystems (8), der zur Erzeugung der Druckdifferenz zum Ansaugen des siliziumbasierten Wafers (2) mit Luft beaufschlagt war, abzuschalten ist.

## Claims

1. Gripper system having a Bernoulli gripper (1) for holding two-dimensional components, such as silicon-based wafers (2), having:
a clamping ring (4) connected to a controllable robot arm (3);
a baffle plate (6) which is connected to the clamping ring (4) by means of a funnel-shaped component (5) and has a gripping face (7), which communicates with a flow system (8) which penetrates the funnel-shaped component (5) and the baffle plate (6), and by means of which, after an excess pressure has been applied to the Bernoulli gripper (1), a negative pressure is to be produced on the gripping face (7) of the baffle plate (6) in order to attach by suction a silicon-based wafer (2) to be gripped; and
a bearing surface (9) of a bearing ring (10), which is integrated in the gripping face (7) and provides a slip-resistant movement of the silicon-based wafer (2) attached to the gripping face (7) by suction,
**characterized by**
a damping device which is circumferentially adapted to the Bernoulli gripper (1), the contour of which device, as viewed in the plan view of the Bernoulli gripper (1), protrudes circumferentially above the contour of the latter, and which is formed by a brush (12) with elastic bristles (13), which viewed in the side view of the Bernoulli gripper (1), protrude over this by a predefined distance (d) and which device forms such a damping resistance for the silicon-based wafer (2) to be gripped during its suction-induced approach towards the gripping face (7) as a first contact, that the silicon-based wafer (2) comes to bear in a shock-relieving manner against the rubberized bearing surface (9) of the bearing ring (10).

2. Gripper system according to Claim 1,
**characterized in that**
the predefined distance (d), according to which the elastic bristles (13) of the brush (12) protrude over the Bernoulli gripper (1), viewed in the side view thereof, is in the range 1.5 mm to 3.5 mm.

3. Gripper system according to any one of the preceding claims,
**characterized in that**
bristle ends (15) of the elastic bristles (13) of the brush (12) facing towards freely terminating bristle ends (14) of the elastic bristles (13) of the brush (12) are fixed in a circumferential brush edge (16), which is retained in a circumferential clamping groove (17) of the Bernoulli gripper (1) in an interchangeable manner, said groove being formed by the clamping ring (4) and the funnel-shaped component (5) .

4. Gripper system according to any one of the preceding claims,
**characterized in that**
viewed in the plan view of the Bernoulli gripper (1), the baffle plate (6) and the brush (12) which forms the damping device are arranged coaxially to the longitudinal axis (18) of the Bernoulli gripper (1) and that an outline of the gripping face (7) of the baffle plate (6) and an outline of the brush (12) are circular.

5. Gripper system according to any one of the preceding claims,
**characterized in that**
the elastic bristles (13) of the brush (12), viewed in the plan view of the Bernoulli gripper (1), form an open circular ring of approximately 340°, wherein the bristle-free ring segment (19) of the brush (12) is spatially assigned to a capacitive sensor (11) for detecting the silicon-based wafer (2) which is held on the gripping face (7) by suction.

6. Gripper system according to any one of the preceding claims,
**characterized in that**
the elastic bristles (13) of the brush (12) are inclined downwards relative to the plane of the gripping face (7) of the baffle plate (6) at an angle of 16.5° ± 1°.

7. Gripper system according to any one of the preceding claims,
**characterized in that**
the elastic bristles (13) of the brush (12) consist of polyamide.

8. Gripper system having a Bernoulli gripper (1) for holding two-dimensional components, such as silicon-based wafers (2), which has:
a clamping ring (4) connected to a controllable robot arm (3);
a baffle plate (6) which is connected to the clamping ring (4) by means of a funnel-shaped component (5) and has a gripping face (7), which communicates with a flow system (8) which penetrates the funnel-shaped component (5) and the baffle plate (6), and by means of which, after an excess pressure has been applied to the Bernoulli gripper (1), a negative pressure is to be produced on the gripping face (7) of the baffle plate (6) in order to attach by suction the silicon-based wafer (2) to be gripped; and
a bearing surface (9) of a bearing ring (10), which is integrated in the gripping face (7) and provides a slip-resistant movement of the silicon-based wafer (2) attached to the gripping face (7) by suction,
**characterized by**
a damping device which is circumferentially adapted to the Bernoulli gripper (1), the contour of which device, as viewed in the plan view of the Bernoulli gripper (1), protrudes circumferentially above the contour of the latter, and which is formed by an internally closed sealing-lip-shaped rubber ring (12a) made of soft material, by means of which the silicon-based wafer (2), in its suction-induced abutment against the bearing surface (9) of the rubberized bearing ring (10) integrated in the gripping face (7), is circumferentially hermetically sealed against the baffle plate (6), which is penetrated by a flow system (8) comprising a first air connection and a second air connection, and which device forms such a damping resistance for the silicon-based wafer (2) to be gripped during its suction-induced approach towards the gripping face (7) as a first contact, that the silicon-based wafer (2) comes to bear in a shock-relieving manner against the rubberized bearing surface (9) of the bearing ring (10), wherein the operation of the Bernoulli gripper (1) is to be switched over to vacuum operation immediately after the suction-induced attachment of the silicon-based wafer (2) to the rubberized bearing surface (9), by activation of a vacuum pump connected to the first air connection of the flow system (8), while at the same time the second air connection of the flow system (8), which was pressurized with air to generate the pressure difference for gripping the silicon-based wafer (2) by suction, is to be switched off.

## Revendications

1. Système de préhenseur avec un préhenseur à effet Bernoulli (1) pour la réception de pièces plates telles que des plaquettes de silicium (2), comprenant :
une bague de serrage (4) reliée à un bras de robot (3) commandable ;
un disque à chicane (6) relié à la bague de serrage (4) par le biais d'un élément en forme d'entonnoir (5), avec une surface de préhension (7) communiquant avec un système d'écoulement (8) traversant l'élément en forme d'entonnoir (5) et le disque à chicane (6), permettant de produire une dépression sur la surface de préhension (7) du disque à chicane (6) pour aspirer une plaquette de silicium (2) à saisir, après application d'une surpression sur le préhenseur à effet Bernoulli (1) ; et
une surface de contact (9) d'une bague d'appui (10), intégrée dans la surface de préhension (7), permettant l'exécution d'un procédé antidérapant de la plaquette de silicium (2) aspirée sur la surface de préhension (7),
**caractérisé par**
un dispositif d'amortissement adapté de façon périphérique au préhenseur à effet Bernoulli (1), dont le contour - dans une vue sur le dessus du préhenseur à effet Bernoulli (1) - fait saillie de façon périphérique par rapport au contour de celui-ci, et lequel est formé par une brosse (12) avec des poils élastiques (13), lesquels - dans une vue latérale du préhenseur à effet Bernoulli (1) - font saillie par (2) à saisir, lorsque celui-ci s'approche sous aspiration de la surface de préhension (7), que la plaquette de silicium (2) touche la surface de contact (9) gommée de la bague d'appui (10) sans subir de choc.

2. Système de préhenseur selon la revendication 1, **caractérisé en ce que** la distance prédéterminée (d), selon laquelle les poils élastiques (13) de la brosse (12) font saillie par rapport au préhenseur à effet Bernoulli (1) - dans une vue latérale de celui-ci - mesure entre 1,5 mm et 3,5 mm.

3. Système de préhenseur selon l'une des revendications précédentes, **caractérisé en ce que** des extrémités de poils (15) des poils élastiques (13) de la brosse (12) opposées à des extrémités de poils (14) libres des poils élastiques (13) de la brosse (12) sont fixées dans un bord de brosse périphérique (16), lequel est maintenu de façon remplaçable dans une rainure de serrage périphérique (17) du préhenseur à effet Bernoulli (1), celle-ci étant formée par la bague de serrage (4) et l'élément en forme d'entonnoir (5).

4. Système de préhenseur selon l'une des revendications précédentes, **caractérisé en ce que** - dans une vue sur le dessus du préhenseur à effet Bernoulli (1) - le disque à chicane (6) et la brosse (12) formant le da sont disposés coaxialement par rapport à l'axe longitudinal (18) du préhenseur à effet Bernoulli (1) et **en ce qu'**un contour de la surface de préhension (7) du disque à chicane (6) et un contour de la brosse (12) sont circulaires.

5. Système de préhenseur selon l'une des revendications précédentes, **caractérisé en ce que** les poils élastiques (13) de la brosse (12) - dans une vue sur le dessus du préhenseur à effet Bernoulli (1) - forment un anneau circulaire ouvert d'environ 340°, la section annulaire exempte de poils (19) de la brosse (12) étant spatialement attribuée à un capteur capacitif (11) chargé de détecter la plaquette de silicium (2) aspirée sur la surface de préhension (7).

6. Système de préhenseur selon l'une des revendications précédentes, **caractérisé en ce que** les poils élastiques (13) de la brosse (12) s'étendent de façon inclinée vers le bas par rapport au plan de la surface de préhension (7) du disque à chicane (6), sous un angle de 16,5° ± 1°.

7. Système de préhenseur selon l'une des revendications précédentes, **caractérisé en ce que** les poils élastiques (13) de la brosse (12) sont constitués de polyamide.

8. Système de préhenseur avec un préhenseur à effet Bernoulli (1) destiné à recevoir des pièces plates, telles que des plaquettes de silicium (2), comprenant :
une bague de serrage (4) reliée à un bras de robot (3) commandable ;
un disque à chicane (6) relié à la bague de serrage (4) par le biais d'un élément en forme d'entonnoir (5), avec une surface de préhension (7) communiquant avec un système d'écoulement (8) traversant l'élément en forme d'entonnoir (5) et le disque à chicane (6), permettant de produire une dépression sur la surface de préhension (7) du disque à chicane (6) pour aspirer une plaquette de silicium (2) à saisir, après application d'une surpression sur le préhenseur à effet Bernoulli (1) ; et
une surface de contact (9) d'une bague d'appui (10), intégrée dans la surface de préhension (7), permettant l'exécution d'un procédé antidérapant de la plaquette de silicium (2) aspirée sur la surface de préhension (7),
**caractérisé par**
un dispositif d'amortissement adapté de façon périphérique au préhenseur à effet Bernoulli (1), dont le contour - dans une vue sur le dessus du préhenseur à effet Bernoulli (1) - fait saillie de façon périphérique par rapport au contour de celui-ci, et lequel est formé une bague en caoutchouc (12a) du genre lèvre d'étanchéité fermée en soi, constituée d'un matériau souple, permettant d'assurer l'étanchéité de la plaquette de silicium (2), dans son application sous aspiration sur la surface de contact (9) gommée de la bague d'appui (10) intégrée dans la surface de préhension (7), hermétiquement et circonférentiellement par rapport au disque à chicane (6), lequel est traversé par le système d'écoulement (8) présentant une première arrivée d'air et une deuxième arrivée d'air, et formant une telle résistance d'amortissement en tant que premier contact pour la plaquette de silicium (2) à saisir, lorsque celui-ci s'approche sous aspiration de la surface de préhension (7), que la plaquette de silicium (2) touche la surface de contact (9) gommée de la bague d'appui (10) sans subir de choc, le fonctionnement du préhenseur à effet Bernoulli (1) devant continuer sous vide immédiatement après l'application sous aspiration de la plaquette de silicium (2) sur la surface de contact (9) gommée, par l'actionnement d'une pompe à vide raccordée à la première arrivée d'air du système d'écoulement (8), tandis que la deuxième arrivée d'air du système d'écoulement (8), auparavant alimentée en air pour produire la différence de pression nécessaire à l'aspiration de la plaquette de silicium (2), doit être désactivée dans le même temps.
